(19) Europäisches Patentamt
European Patent Office
Office européen des brevets

(11) **EP 0 550 823 B1**

(12) **EUROPÄISCHE PATENTSCHRIFT**

(45) Veröffentlichungstag und Bekanntmachung des Hinweises auf die Patenterteilung:
**20.03.1996 Patentblatt 1996/12**

(51) Int Cl.[6]: **H02H 9/02**

(21) Anmeldenummer: **92119957.6**

(22) Anmeldetag: **24.11.1992**

(54) **Verfahren zur Begrenzung des Stromes über ein Stellglied sowie Anordnung**

Procedure for the limitation of the current across a servo component and equipment

Procédé pour la limitation du courant au-dessus de composant de réglage et le dispositif

(84) Benannte Vertragsstaaten:
**BE DE FR GB IT NL**

(30) Priorität: **27.11.1991 DE 4138989**

(43) Veröffentlichungstag der Anmeldung:
**14.07.1993 Patentblatt 1993/28**

(73) Patentinhaber: **ANT Nachrichtentechnik GmbH D-71522 Backnang (DE)**

(72) Erfinder: **Ohms, Franz, Dipl.-Ing. W-7163 Oberrot (DE)**

(56) Entgegenhaltungen:
EP-A- 0 184 609      EP-A- 0 477 165
DE-A- 3 323 905      DE-A- 3 535 864
DE-A- 4 012 356

• **U. TIETZE et al.: "Halbleiter-Schaltungstechnik", 2. Auflage, 1971, Springer Verlag Berlin-Heidelberg-New York, Seiten 338-340**

**Beschreibung**

Die Erfindung geht aus von einem Verfahren gemäß dem Oberbegriff des Patentanspruchs 1.

Aus DE 40 12 356 A1 ist es bekannt, die verlustleistung oder eine der Verlustleistung entsprechende Größe eines Schalttransistors zu ermitteln und davon abhängig den Basisstrom zu variieren.

Bei Längsreglern wird üblicherweise zur Begrenzung des Stromes über das Stellglied eine zum Strom proportionale Spannung ermittelt und in Abhängigkeit davon das Stellglied gesteuert. Aus Tietze/Schenk, Halbleiterschaltungstechnik, 2. Auflage 1971, Seiten 338 und 339 ist es bekannt, zur Verhinderung der Überlastung des Stellgliedes im Kurzschlußfall den Strom auf einen Bruchteil des Maximalstroms herabzusetzen.

Aufgabe vorliegender Erfindung ist es, eine sichere Strombegrenzung aufzuzeigen, die sowohl statisch als auch dynamisch (plötzliche Laständerungen) wirkt. Die Aufgabe wird bezüglich des Verfahrens durch die Merkmale des Patentanspruchs 1 und bezüglich der Anordnung durch die Merkmale des Patentanspruchs 5 gelöst. Die übrigen Patentansprüche zeigen Ausgestaltungen des Verfahrens/der Anordnung auf.

Die Maßnahmen der Erfindung wiesen sowohl die Vorteile eines Serien- oder Parallelreglers (sofortige Reaktion auf Laständerungen ohne Schaltverluste) als auch die Vorteile eines Schaltreglers (verlustarme Regelung) auf, ohne daß sich jedoch deren Nachteile gravierend bemerkbar machen. Die Erfindung stellt sicher, daß unter allen Umständen das Stellglied vor Überlastung geschützt ist, so daß ihr Einsatz unter besonders kritischen Bedingungen, z. B. in Satellitenstromversorgungssystemen, möglich ist. Da sich die Strombegrenzung gemäß der Erfindung selbst regelt, kann der arithmetische Mittelwert für die Verlustleistung am Stellglied vorgegeben werden und die Strombegrenzung sorgt selbsttätig dafür, daß dieser vorgegebene Mittelwert nicht überschritten wird.

Anhand der Zeichnungen werden Ausführungsbeispiele der Erfindung näher erläutert. Es zeigen

Fig. 1 ein Prinzipschaltbild einer Strombegrenzung

Fig. 2 die Kennlinie des Serienreglers,

Fig. 3 die Spannung am Integrationsglied und den Zustand des Stellgliedes für verschiedene Betriebsfälle,

Fig. 4 ein Prinzipschaltbild der Strombegrenzung mit zwei parallel arbeitenden Stellglieder und

Fig. 5 die Ausgestaltung der gesteuerten Stromquelle.

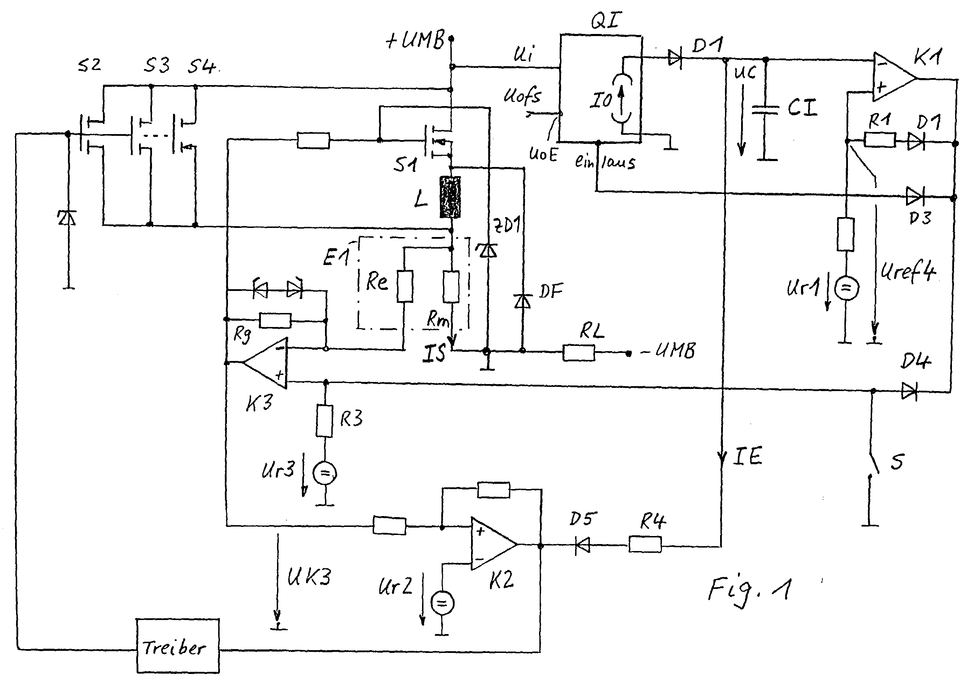

Fig. 1 zeigt ein Ausführungsbeispiel einer Strombegrenzung, welche zwischen der Main-Bus-Spannung UMB eines Satelliten und einer Last RL vorgesehen ist. Das Stellglied S1 ist als n-Kanal MOS-Feldeffekttransistor ausgebildet. In Serie zu seiner Drain-Source Strecke ist die Induktivität L und der Strommeßwiderstand Rm angeordnet. Zwischen Gate und dem schalterabgewandten Ende des Strommeßwiderstandes Rm ist eine Zenerdiode ZD1 als statisches Strombegrenzungselement vorgesehen, deren Katode zum Gate weist. Die Serienschaltung bestehend aus Strommeßwiderstand Rm und Induktivität L ist durch eine Freilaufdiode DF überbrückt. Der Verbindungspunkt der Induktivität L mit dem Strommeßwiderstand Rm steht über den weiteren Widerstand Re als Teil der Einrichtung E1 zur Auswertung des Hauptstromes IS über das Stellglied S1 mit dem invertierenden Eingang des Komparators K3 in Wirkverbindung. Der nichtinvertierende Eingang des Komparators K3 ist mit einer Referenzspannungsquelle Ur3 über den Widerstand R3 verbunden. Der Fußpunkt dieser Referenzspannungsquelle Ur3 ist gemeinsam mit dem schalterabgewandten Ende des Strommeßwiderstandes Rm, bzw. der Anode der Zenerdiode ZD1 an Massepotential angeschlossen. Zwischen dem invertierenden Eingang des Komparators K3 und dem Ausgang, der zum Gate des Feldeffekttransistors S1 führt, ist ein Gegenkopplungswiderstand Rg vorgesehen, der durch die Antiseriellschaltung der Zenerdioden ZD2 und ZD3 überbrückt ist. Gegebenenfalls kann zum Widerstand Rg noch eine Kapazität parallel geschaltet werden. Das Stellglied S1 wirkt zusammen mit den zuvor beschriebenen Baugruppen als Serienregler zwischen Main-Bus und Last RL.

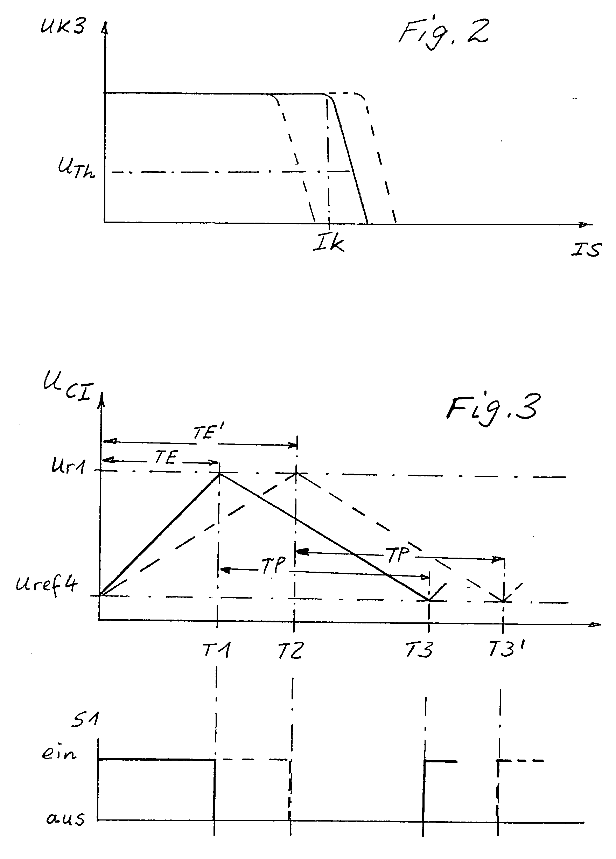

Im Gegensatz zur Stromauswerteeinrichtung gemäß EP 0 184 609 oder DE 33 23 905 C2 ist die Kennlinie des beschalteten Komparators K3 -Ausgangsspannung $UK3 = f($Strom IS durch den Feldeffekttransistor$)$ - nicht linear ansteigend, sondern, vgl. Fig. 2, zuerst konstant und fällt bei Erreichen eines vorgegebenen Stromes Ik linear steil nach unten ab. Sobald die Ausgangsspannung UK3 kleiner wird als die Thresholdspannung $U_{Th}$ des Feldeffekttransistor beginnt dieser n-Kanal MOSFET zu sperren.

Es gilt:

$$UK3 = Ur3 \left(1 + \frac{Rg}{Re}\right) - \frac{Rm \times Rg}{Re} \times IS$$

Der Komparator K3 ist also invertierend beschaltet (abfallende Kennlinie). Der abfallende Teil der Kennlinie und damit der Beginn des Abfalls lässt sich durch Einstellen der Referenzspannung Ur3 parallel nach links oder rechts (gestrichelt in Fig. 2) verschieben. Der konstante Teil der Kennlinie, d. h. die Höhe der Ausgangsspannung UK3 hängt von den Werten der Schwellwertdioden ZD2 und ZD3 ab.

Die Induktivität L dient zur dynamischen Strombegrenzung und wirkt insbesondere bei sprungartigen Kurzschlüssen. Durch die Beschaltung mit der Zenerdiode ZD1 fällt über dieser Induktivität L nur die Differenz aus der Zenerspannung der Zenerdiode ZD1 und der Thresholdspannung $U_{Th}$ des MOSFET S1 ab. Da diese Spannung relativ niedrig ist, kann die Induktivität L bei voller Wirksamkeit im Kurzschlußfall sehr klein gewählt werden.

Der Komparator K3 ist als Verstärker mit P-Verhalten beschaltet. Da integrierende Elemente nicht vorhanden sind, bzw. kaum eine Rolle spielen, wirkt er auch sehr schnell auf sprungartige Laständerungen und begrenzt automatisch den Strom bei solchen Betriebsfällen.

Erfindungsgemäß ist eine spannungsgesteuerte Stromquelle QI vorgesehen, welche in Abhängigkeit des Spannungsabfalls Ui am Stellglied S1 einen niedrigen oder höheren Strom IO abgibt. Die spannungsgesteuerte Stromquelle QI beginnt jedoch erst zu arbeiten, wenn der Spannungsabfall Ui größer wird als eine Offsetspannung Uofs, die der Stromquelle QI über einen Offsetspannungseingang UoE zugeführt wird. Übersteigt der Spannungsabfall Ui die Offsetspannung Uof, arbeitet das Stellglied S1 im Strombegrenzungsbetrieb (der beschaltete Komparator K3 liefert eine geringere Gatespannung für das Stellglied S1). Über die Diode D1 fließt der Ausgangsstrom IO der Stromquelle QI zum invertierenden Eingang des Komparators K1 wie auch zu einem Integrationsglied - Kondensator CI. Der Ausgangsstrom IO der gesteuerten Stromquelle QI kann als ein Signal, welches proportional zur Verlustleistung, die das Stellglied S1 aufnimmt, angesehen werden (Begrenzungsstrom IS ist bekannt und nahezu konstant über der gesamten anliegenden Spannung UMB). Dieses Signal wird nun am Integrationskondensator CI aufsummiert und mit der Referenzspannung Ur1 verglichen. Die Spannung UC am Integrationskondensator CI ist nun ein Maß für die Verlustenergie, welche vom Stellglied S1 aufgenommen wurde.

Die Referenzspannung Ur1 wird nun so gewählt, daß die Verlustenergie, welche das Stellglied S1 aufnehmen kann, nicht überschritten wird. Dadurch ist es möglich, das Stellglied immer bei der gleichen Verlustenergie abzuschalten. Dies bedeutet, daß das Stellglied S1 bei vollem Kurzschluß über der Last RL schneller abschaltet (Fig. 3, Zeitpunkt T1), als wenn noch eine Teilspannung über der Last RL abfällt (Fig. 3, Zeitpunkt T2).

Hat der Komparator K1 angesprochen (UC > Ur1), so wird über die Diode D3 die gesteuerte Stromquelle QI abgeschaltet. Gleichzeitig wird das Stellglied S1 ganz abgeschaltet, indem über die Diode D4 dem nichtinvertierenden Eingang des Komparators K3 eine Referenzspannung O oder sogar eine negative Referenzspannung vorgetäuscht wird..

Ein weiterer Komparator K2, der die Ausgangsspannung UK3 des Komparators K3 überwacht, spricht an, sobald das Stellglied S1 zu regeln (Strombegrenzungsbetrieb) beginnt (UK3 > Ur2).

Dieser Komparator K2 liefert dann ein Abschaltsignal für einen oder mehrere elektronische Schalter S2, S3, S4, die zur niederohmigen Überbrückung und damit zur Reduzierung von Verlusten vorgesehen sind, wenn das Stellglied S1 nicht im Strombegrenzungsbetrieb arbeitet. Gleichzeitig aktiviert der Komparator K2 einen Entladekreis für den Integrationskondensator CI - Verbindung der potentialführenden Elektrode des Kondensators CI über den Widerstand R4 und die Diode D5 mit dem Ausgang des Komparators K2-der nach Ansprechen des Komparators K2 Massepotential führt. Der Entladestrom IE entspricht einer Verlustleistung, die das Stellglied S1 statisch aufnehmen kann:

IE ~ P$_V$stat.

Hat der Komparator K1 angesprochen, so wird über den Widerstand R1 und die Diode D2 die Schwelle für diesen Komparator erniedrigt. Demzufolge bleibt das Stellglied S1 so lange abgeschaltet, bis durch die Entladung des Kondensators CI seine Spannung UC auf diese niedrigere Schwelle (Uref4) abgesunken ist (Fig. 3, Zeitpunkt T3 bzw. T3'). Wenn diese niedrigere Schwelle (Uref4) erreicht ist, ändert sich das Ausgangspotentials des Komparators K1. Das Sperrpotential für den Komparator K3, das über die Diode D4 zugeleitet wurde, verschwindet, sodaß das Stellglied S1 automatisch wieder einschaltet. Gleichzeitig kann die Stromquelle QI, wenn der Spannungsabfall Ui genügend groß wird, über die Diode D3 wieder aktiviert werden.

Wie Fig. 3 zeigt, hängt die Einschaltzeit TE bzw. TE' des Stellgliedes S1 von der dynamischen Belastung ab, wohingegen die Pausenzeit TP immer gleich groß ist und in Abhängigkeit der statischen Verlustenergie gewählt ist. Über einen Schalter S am Ausgang des Komparators K1 ist eine manuelle Steuerbarkeit der Strombegrenzungsschaltung möglich.

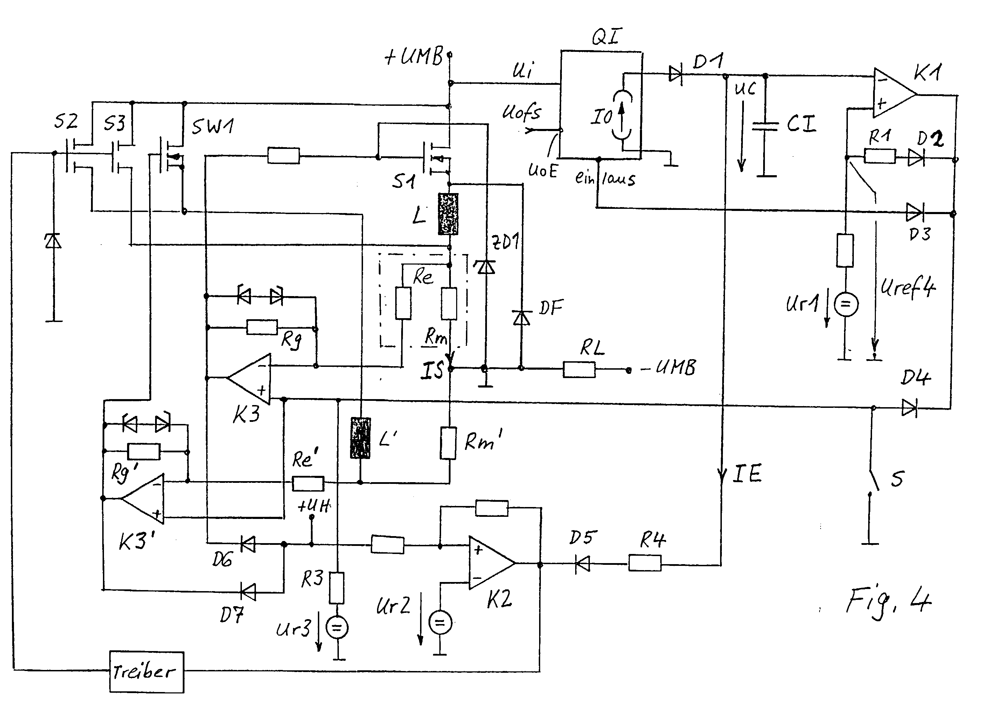

Fig. 4 zeigt eine Ausgestaltung bei der zum Stellglied S1 ein weiteres Stellglied SW1 parallel betrieben wird. Entsprechend zum Ausführungsbeispiel gemäß Fig. 1 sind für das weitere Stellglied SW1 ein Komparator K3', auf den gleichen Fußpunkt bezogene Stromerfassungswiderstände Rm' und Re', eine Induktivität L', sowie ein Gegenkopplungswiderstand Rg' vorgesehen. Die Komparatoren K3 und K3' werden von der gemeinsamen Referenzspannung Ur3 bzw. dem über D4 Zugeführten Blockiersignal gesteuert. Zur gegenseitigen Entkopplung der Ausgänge der Komparatoren K3 und K3' sind die Entkopplungsdioden D6 und D7 vorgesehen, die über eine Hilfsspannung UH vorgespannt sind.

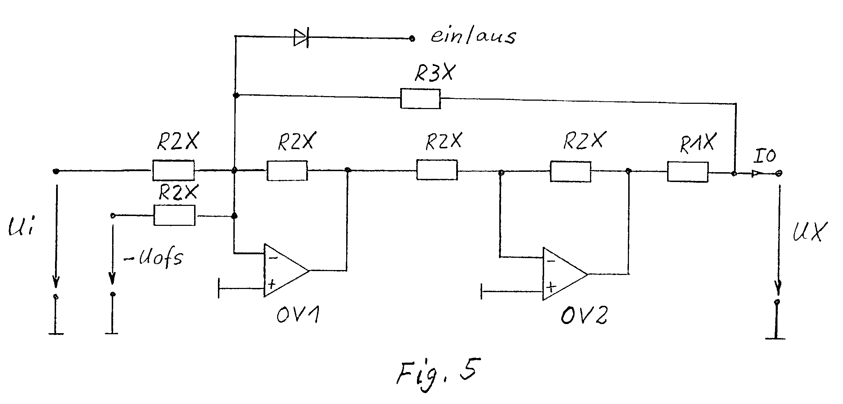

Für die gesteuerte Stromquelle QI kann eine aus Tietze/Schenk, Halbleiterschaltungstechnik, Seite 356, Abb. 13.10, bekannte Anordnung in der nach Fig. 5 modifizierten Version eingesetzt werden. Bei Dimensionierung der Beschaltungswiderstände R1X, R2X, R3X der beiden Operationsverstärker OV1 und OV2 gemäß der Abgleichbedingung: R3X = R2X - R1X ist der Ausgangsstrom IO unabhängig von der Ausgangsspannung UX.

Die Widerstände Rm und Re können vorteilhafterweise thermisch gekoppelt werden und so ausgestaltet und zusammengeschaltet sein, daß sich die Temperaturgänge ihrer parasitären Induktivitäten einander kompensieren. Nähere Einzelheiten für eine solche Ausgestaltung sind der EP 0 184 609 B1 zu entnehmen. In einer weiteren Ausgestaltung kann der ohmsche Wicklungswiderstand der Induktivität L bzw. L' für die Stromauswertung mit herangezogen werden, wobei ebenfalls der Temperaturgang kompensiert werden kann. Nähere Einzelheiten hierzu finden sich in DE 33 23 905 C2.

**Patentansprüche**

1. Verfahren zur Begrenzung des Stromes über ein Stellglied, welches Bestandteil eines Serien- oder parallelreglers ist, wobei die vom Stellglied (S1) aufgenommene Verlustenergie oder eine der Verlustenergie entsprechende Größe ermittelt wird, dadurch gekennzeichnet, daß bei Erreichen eines vorgegebenen Wertes dieser Verlustenergie das Stellglied (S1) für eine vorgegebene Pausenzeit abgeschaltet wird.

2. Verfahren nach Anspruch 1, dadurch gekennzeichnet, daß das Stellglied (S1) außerhalb seines Regelbetriebs niederohmig überbrückt wird.

3. Verfahren nach Anspruch 1 oder 2, dadurch gekennzeichnet, daß der Spannungsabfall (Ui) über dem Stellglied (S1) erfasst wird, daß bei einem vorgegebenen Wert (Uofs) dieses Spannungsabfalls, der den Beginn des Strombegrenzungsbetriebs des Stellgliedes (S1) anzeigt, eine Stromquelle (QI) eingeschaltet und in Abhängigkeit des Spannungsabfalls über dem Stellglied (S1) gesteuert wird, daß der von dieser Stromquelle (QI) gelieferte Strom (IO) aufsummiert (CI) wird und daß bei Erreichen einer vorgegebenen Stromsumme, die der maximal zulässigen Verlustenergie des Stellgliedes (S1) entspricht, das Stellglied (S1) für die vorgegebene Pausenzeit abgeschaltet wird.

4. Verfahren nach einem der Ansprüche 1 bis 3, dadurch gekennzeichnet, daß die Pausenzeit in Abhängigkeit der vom Stellglied (S1) statisch aufnehmbaren Verlustenergie gewählt ist.

5. Anordnung zur Begrenzung des Stromes über ein Stellglied (S1) mit folgenden Merkmalen:

   - ein Stellglied (S1), als Bestandteil eines Serien- oder Parallelreglers,
   - eine in Abhängigkeit des Spannungsabfalls am Stellglied (S1) steuerbare Stromquelle (QI),
   - ein Integrationsglied (CI) für den von der Stromquelle (QI) gelieferten Strom (IO),
   - einen ersten Komparator (K1) zum Vergleich der Spannung (UC) am Integrationsglied (CI) mit einer ersten Referenzspannung (Ur1) und zur Abgabe eines Abschaltsignals für das Stellglied (S1) und die Stromquelle (QI), wenn die Spannung am Integrationsglied (CI) größer wird als die erste Referenzspannung (Ur1),

   - Mitteln (QI, CI, D2, R1, K1) zum Vorgeben einer Pausenzeit für das Stellglied (S1) nach dem Abschalten.

6. Anordnung nach Anspruch 5, dadurch gekennzeichnet, daß die Stromquelle (QI) mit einem Offsetspannungseingang (UoEf) versehen ist, der eine Aktivierung der Stromquelle (QI) erst dann gestattet, wenn der Spannungsabfall am Stellglied (S1) größer wird als diese Offsetspannung (Uof).

7. Anordnung nach einem der Ansprüche 5 oder 6, dadurch gekennzeichnet, daß die Stromquelle (QI) derart ausgebildet ist, daß ihr Ausgangsstrom unabhängig von ihrer Ausgangsspannung ist.

8. Anordnung nach einem der Ansprüche 5 bis 7, dadurch gekennzeichnet, daß ein oder mehrere elektronische Schalter (S2, S3, S4) zur Überbrückung des Stellgliedes (S1) vorgesehen sind, daß ein zweiter Komparator (K2) vorgesehen ist, der anspricht, sobald das Stellglied (S1) in den Strombegrenzungsbetrieb übergeht und der dann ein Abschaltsignal für den/die elektronischen Schalter (S2, S3, S4) liefert.

9. Anordnung nach Anspruch 8, dadurch gekennzeichnet, daß der zweite Komparator (K2) auch dazu vorgesehen ist, einen Entladekreis für das Integrationsglied (CI) zu aktivieren.

10. Anordnung nach einem der Ansprüche 5 bis 9, dadurch gekennzeichnet, daß dem ersten Komparator (K1) eine Schwellwertumschalteinrichtung (D2, R1) zugeordnet ist, die dafür sorgt, daß das Abschaltsignal für das Stellglied (S1) so lange geliefert wird, bis sich das Integrationsglied (CI) auf einen vorgegebenen Spannungswert entladen hat.

11. Anordnung nach einem der Ansprüche 5 bis 10, dadurch gekennzeichnet, daß der Regler aus folgenden Baugruppen besteht:

    - einem elektronischen Schalter (S1) als Stellglied (S1),
    - einer Induktivität (L) in Serie zu diesem elektronischen Schalter (S1),
    - einem Strombegrenzungselement (ZD1) zwischen der Steuerelektrode des elektronischen Schalters (S1) und einem Anschlußpunkt im Hauptstromkreis des elektronischen Schalters (S1),
    - einer Einrichtung (E1) zum Erfassen des Hauptstromes (IS) über den elektronischen Schalter,
    - einem dritten Komparator (K3) zwischen der Einrichtung (E1) zum Erfassen des Hauptstromes und der Steuerelektrode des elektronischen Schalters (S1), welcher derart beschaltet ist, daß seine Ausgangsspannung (UK3) bei einem niedrigen Strom (IS) über das Stellglied (S1) konstant ist und bei Erreichen eines vorgebbaren Maximalstromes steil abfällt.

12. Anordnung nach Anspruch 11, dadurch gekennzeichnet, daß mindestens ein weiteres Stellglied (SW1) vorgesehen ist, welches ebenso beschaltet ist, wie das Stellglied (S1) und parallel zu letzterem arbeitet.

**Claims**

1. Method for limiting the current via an actuator which is part of a series or parallel regulator, the power loss taken up by the actuator (S1) or a variable corresponding to the power loss being determined, characterized in that when a predetermined value of this power loss is reached, the actuator (S1) is disconnected for a predetermined off period.

2. Method according to Claim 1, characterized in that the actuator (S1) is bridged at low impedance when it is not in its regulating mode.

3. Method according to Claim 1 or 2, characterized in that the voltage drop (Ui) across the actuator (S1) is detected, in that a current source (QI) is switched on and controlled as a function of the voltage drop across the actuator (S1) at a predetermined value (Uofs) of this voltage drop which indicates the start of the current limiting operation of the actuator (S1), in that the current (IO) supplied by this current source (QI) is summed (CI), and in that when a predetermined current sum which corresponds to the maximum permissible power loss of the actuator (S1) is reached, the actuator (S1) is disconnected for the predetermined off period.

4. Method according to one of Claims 1 to 3, characterized in that the off period is selected as a function of the power loss which can be taken up by the actuator (S1) in the steady state.

5. Arrangement for limiting the current via an actuator (S1), having the following features:

   - an actuator (S1) as part of a series or parallel regulator,
   - a current source (QI) which can be controlled as a function of the voltage drop across the actuator (S1),
   - an integration element (CI) for the current (IO) supplied by the current source (QI),
   - a first comparator (K1) for comparing the voltage (UC) across the integration element (CI) with a first reference voltage (Ur1) and for emitting a disconnection signal for the actuator (S1) and the current source (QI) when the voltage across the integration element (CI) becomes greater than the first reference voltage (Ur1),
   - means (QI, CI, D2, R1, K1) for predetermining an off period for the actuator (S1) after disconnection.

6. Arrangement according to Claim 5, characterized in that the current source (QI) is provided with an offset voltage input (UoEf), which allows the current source (QI) to be activated only when the voltage drop across the actuator (S1) becomes greater than this offset voltage (Uof).

7. Arrangement according to one of Claims 5 and 6, characterized in that the current source (QI) is designed in such a way that its output current is independent of its output voltage.

8. Arrangement according to one of Claims 5 to 7, characterized in that one or more electronic switches (S2, S3, S4) are provided for bridging the actuator (S1), in that a second comparator (K2) is provided, which responds as soon as the actuator (S1) changes to the current limiting operation, and which then supplies a disconnection signal for the electronic switch(es) (S2, S3, S4).

9. Arrangement according to Claim 8, characterized in that the second comparator (K2) is also provided for activating a discharge circuit for the integration element (CI).

10. Arrangement according to one of Claims 5 to 9, characterized in that there is assigned to the first comparator (K1) a threshold value changeover device (D2, R1), which ensures that the disconnection signal for the actuator (S1) is supplied until the integration element (CI) has been discharged to a predetermined voltage value.

11. Arrangement according to one of Claims 5 to 10, characterized in that the regulator comprises the following assemblies:

    - an electronic switch (S1) as the actuator (S1),
    - an inductor (L) in series with this electronic switch (S1),
    - a current limiting element (ZD1) between the control electrode of the electronic switch (S1) and a junction point in the main circuit of the electronic switch (S1),
    - a device (E1) for detecting the main current (IS) via the electronic switch,
    - a third comparator (K3) between the device (E1) for detecting the main current and the control electrode of the electronic switch (S1), which third comparator is wired up in such a way that its output voltage (UK3) is constant in the event of a low current (IS) via the actuator (S1) and drops rapidly in the event of a predeterminable maximum current being reached.

12. Arrangement according to Claim 11, characterized in that at least one further actuator (SW1) is provided, which is wired up in the same way as the actuator (S1) and operates in parallel with the latter.

## Revendications

1. Procédé pour limiter l'intensité du courant dans un organe de réglage faisant partie d'un régulateur série ou parallèle, procédé selon lequel on détermine la perte d'énergie reçue par l'organe de réglage (S1) ou une grandeur correspondant à cette perte d'énergie, caractérisé en ce que, lorsqu'on atteint une valeur prédéterminée de cette perte d'énergie, l'organe de réglage (S1) est coupé pour un temps de pause prédéterminé.

2. Procédé selon la revendication 1, caractérisé en ce que l'organe de réglage (S1) est shunté par une résistance faiblement ohmique en dehors de son mode de fonctionnement en régulation.

3. Procédé selon la revendication 1 ou 2, caractérisé en ce qu'on détecte la chute de tension (Ui) aux bornes de l'organe de réglage (S1) et, pour une valeur prédéterminée (Uofs) de cette chute de tension qui indique le début du mode de fonctionnement en limitation de courant de l'organe de réglage (S1), on branche une source de courant (QI), on commande en fonction de la chute de tension aux bornes de l'organe de réglage (S1), on additionne le courant (IO) fourni par cette source de courant (QI) et, lorsqu'on atteint une somme d'intensité prédéterminée qui correspond à la perte d'énergie maximale autorisée de l'organe de réglage (S1), on coupe l'organe de réglage (S1) pour le temps de pause prédéterminé.

4. Procédé selon l'une des revendications 1 à 3, caractérisé en ce qu'on choisit le temps de pause en fonction de la perte d'énergie que peut recevoir statiquement l'organe de réglage (S1).

5. Dispositif pour limiter l'intensité du courant dans un organe de réglage (S1) ayant les caractéristiques suivantes :

   - un organe de réglage (S1) faisant partie d'un régulateur série ou parallèle,
   - une source de courant (QI) commandée en fonction de la chute de tension aux bornes de l'organe de réglage (S1),
   - un élément d'intégration (CI) pour le courant (IO) fourni par la source de courant (QI),
   - un premier comparateur (K1) pour comparer la tension (UC) de l'organe d'intégration (CI) à une première tension de référence (Ur1) et pour fournir un signal de coupure à l'organe de réglage (S1) et à la source de courant (QI) lorsque la tension de l'organe d'intégration (CI) dépasse la première tension de référence (Ur1),
   - des moyens (QI, CI, D2, R1, K1) pour prédéterminer un temps de pause pour l'organe de réglage (S1) après la coupure.

6. Dispositif selon la revendication 5, caractérisé en ce que la source de courant (QI) a une entrée de tension de décalage (UoEf) qui ne permet d'activer la source de courant (QI) que lorsque la chute de tension sur l'organe de réglage (S1) dépasse cette tension de décalage (Uof).

7. Dispositif selon l'une des revendications 5 ou 5, caractérisé en ce que la source de courant (QI) est réalisée pour que son courant de sortie soit indépendant de sa tension de sortie.

8. Dispositif selon l'une des revendications 5 à 7, caractérisé par un ou plusieurs commutateurs électroniques (S2, S3, S4) pour shunter l'organe de réglage (S1), un second comparateur (K2) étant prévu pour se mettre en oeuvre dès que l'organe de réglage (S1) passe en mode de limitation de courant et pour fournir un signal de coupure pour le ou les commutateurs électroniques (S2, S3, S4).

9. Dispositif selon la revendication 8, caractérisé en ce que le second comparateur (K2) est également prévu pour activer un circuit de décharge pour l'élément d'intégration (CI).

10. Dispositif selon l'une des revendications 5 à 9, caractérisé en ce qu'une installation à seuils (D2, R1) est associée au premier comparateur (K1), cette installation assurant que le signal de coupure de l'organe de réglage (S1) soit fourni jusqu'à ce que l'élément d'intégration (CI) soit déchargé à une tension prédéterminée.

11. Dispositif selon l'une des revendications 5 à 10, caractérisé en ce que le régulateur se compose des ensembles suivants :

   - un commutateur électronique (S1) constituant l'organe de réglage (S1),
   - une inductance (L) en série avec ce commutateur électronique (S1),
   - un élément de limitation de courant (ZD1) entre l'électrode de commande du commutateur électronique (S1) et un point de branchement dans le circuit principal du commutateur électronique (S1),

- une installation (E1) pour détecter l'intensité principale (IS) dans le commutateur électronique,

- un troisième comparateur (K3) entre l'installation (E1) pour détecter le courant principal, et l'électrode de commande du commutateur électronique (S1), branché pour que sa tension de sortie (UK3) soit constante pour une intensité faible (IS) dans l'organe de réglage (S1), et chute brusquement lorsqu'on atteint un courant maximum prédéterminé.

12. Dispositif selon la revendication 11, caractérisé par au moins un second organe de réglage (SW1) branché également comme l'organe de réglage (S1) et fonctionnant en parallèle à celui-ci.

Fig. 1

EP 0 550 823 B1

UK3

Fig. 2

UTh

Ik

IS

UCI

Fig. 3

Ur1

TE'

TE

Uref4

TP

TP'

T1    T2        T3    T3'

S1

ein

aus

Fig. 4

EP 0 550 823 B1

Fig. 5